# EUROPEAN PATENT APPLICATION

(11) **EP 4 794 479 A1**
(43) Date of publication of application: **19.08.2026**
(21) Application number: 25175221.8
(22) Date of filing: 09.05.2025
(51) Int. Cl.: H10D 86/01, H10D 84/01, H10D 86/00, H10D 30/69

(54) **CONTACT STRAP EXTENDING TO COMMON SOURCE/DRAIN REGION OF ADJACENT GATE STRUCTURES**

(30) Priority: 13.02.2025 US 202519052628
(71) Applicant: GlobalFoundries U.S. Inc., Malta, NY 12020 (US)
(72) Inventor: MULFINGER, George Robert, Malta, NY 12020 (US); SHANBHAG, Kaustubh, Malta, NY 12020 (US); PRITCHARD, David Charles, Malta, NY 12020 (US); FEUILLETTE, Romain Herve Aurelien, Essex Junction, VT 05452 (US)
(74) Representative: Lambacher, Michael

(57) **Abstract**

The present disclosure relates to semiconductor structures and, more particularly, to a contact strap extending to a common source/drain region of adjacent gate structures and methods of manufacture. The structure includes: a first gate structure; a second gate structure adjacent to the first gate structure; a common diffusion region to the first gate structure and the second gate structure; a trench lined with insulator material; and a contact strap extending within the trench and connecting to the common diffusion region.

## Description

### BACKGROUND

The present disclosure relates to semiconductor structures and, more particularly, to a contact strap extending to a common source/drain region of adjacent gate structures and methods of manufacture.

Integrated circuits (ICs) are devices with multiple functional elements mounted on a chip. Integrated circuits (ICs) are broadly classified into analog, digital, and mixed-signal categories. These classifications encompass a range of functionalities, with mixed-signal ICs specifically designed to integrate both analog and digital signaling on a single chip. For example, typical ICs include memories, microprocessors (MPUs), and logic ICs. The size of integrated circuit devices continues to decrease resulting in considerable increase of packing densities and performance. The smaller scale and denser integrated circuit devices requires precision manufacturing controls to ensure reliability and perform of the IC.

### SUMMARY

In an aspect of the disclosure, a structure comprises: a first gate structure; a second gate structure adjacent to the first gate structure; a common diffusion region to the first gate structure and the second gate structure; a trench lined with insulator material; and a contact extending within the trench and connecting to the common diffusion region.

The structure may further comprise a shallow trench isolation structure under the trench.

The contact strap of the structure may extend over the insulator material of the trench. Further, the trench may be between the first gate structure and the second gate structure.

Additionally or alternatively, the insulator material within the trench may comprise a first insulator material and a second insulator material. The first insulator material may comprise oxide material and the second insulator material may comprise nitride material. Additionally or alternatively, the first insulator material and the second insulator material may be provided between the contact strap and an underlying semiconductor substrate.

Additionally or alternatively, the trench may be formed in a top semiconductor layer of a semiconductor-on-insulator semiconductor substrate. Optionally, the trench may further extend to an underlying buried insulator material.

Additionally or alternatively, the insulator material may comprise stress materials adjacent to the first gate structure and the second gate structure. According to one variant, the first gate structure and the second gate structure may comprise NFETs and the stress materials may comprise nitride material.

Additionally or alternatively, the common diffusion region may comprise a raised epitaxial diffusion region facing sides of the first gate structure and the second gate structure.

In an aspect of the disclosure, a structure comprises: a trench structure lined with insulator materials; adjacent gate structures with a common diffusion region on opposing sides of the trench structure; a shallow trench isolation structure underneath the trench structure; and a contact extending over the trench structure and the shallow trench isolation structure and connecting to the common diffusion region.

The insulator materials within the trench structure may comprise a nitride material over an oxide material. Additionally or alternatively, the contact may extend within the trench structure over the nitride material. Additionally or alternatively, the trench structure may extend to a buried insulator layer underneath a semiconductor on insulator substrate.

Additionally or alternatively, the first gate structure and the second gate structure may be NFETs and the insulator materials may comprise stress materials for the NFETs. Optionally, the adjacent gate structures may be lined with the stress materials.

Additionally or alternatively, the common diffusion region may comprise a raised diffusion region.

In an aspect of the disclosure, a method comprises: forming a first gate structure; forming a second gate structure adjacent to the first gate structure; forming a common diffusion region to the first gate structure and the second gate structure; forming a trench lined with insulator material; and forming a contact strap extending within the trench and connecting to the common diffusion region.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIGS. 2A-2F show respective fabrication processes for manufacturing the structure of FIG. 1 in accordance with aspects of the present disclosure.

### DETAILED DESCRIPTION

The present disclosure relates to semiconductor structures and, more particularly, to a contact strap extending to a common source/drain region of adjacent gate structures and methods of manufacture. More specifically, the contact strap extends over a trench positioned between the adjacent gate structures and contacts to the common source/drain regions of the adjacent gate structures. In embodiments, the trench is lined with insulator material and is positioned over a shallow trench isolation structure. The lined trench structure will prevent the contact strap from shorting to the underlying semiconductor substrate. Advantageously, the contact strap improves RF performance, in addition to providing routing benefits and usage of a reduced area.

The structure of the present disclosure can be manufactured in a number of ways using a number of different tools. In general, though, the methodologies and tools are used to form structures with dimensions in the micrometer and nanometer scale. The methodologies, i.e., technologies, employed to manufacture the structure of the present disclosure have been adopted from integrated circuit (IC) technology. For example, the structures are built on wafers and are realized in films of material patterned by photolithographic processes on the top of a wafer. In particular, the fabrication of the structure uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

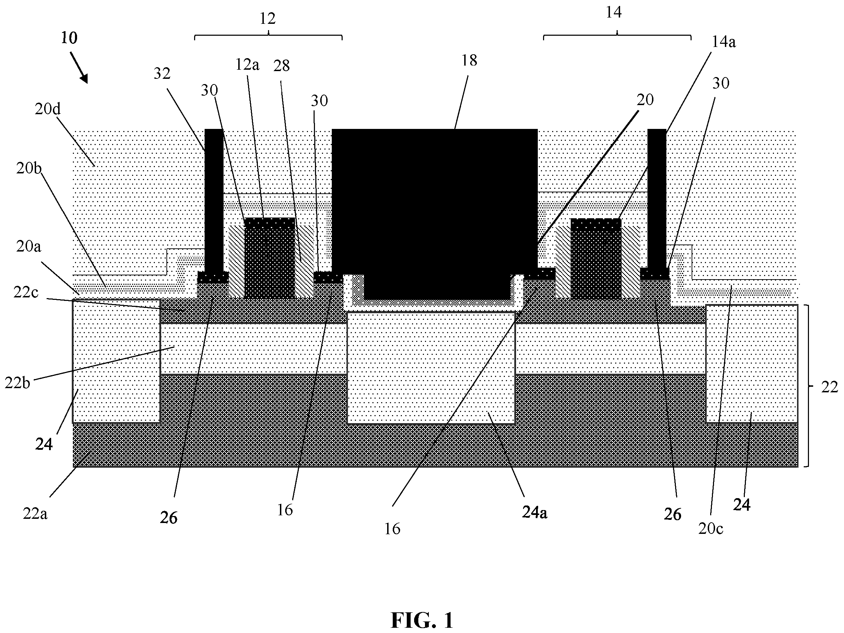

FIG. 1 shows a structure and respective fabrication processes in accordance with aspects of the present disclosure. In embodiments, the structure 10 of FIG. 1 includes adjacent gate structures 12, 14 with a common source/drain region 16. The adjacent gate structures 12, 14 may be, for example, field effect transistors (FETs). In embodiments, a contact strap 18 electrically and physically connects (e.g., contacts) to the common source/drain region 16. The contact strap 18 may extend over (e.g., straddle) a lined trench structure 20 that is between the adjacent gate structures 12, 14. The lined trench structure 20 will also extend over a shallow trench isolation structure 24, 24a under and between the adjacent gate structures 12, 14. In embodiments, the shallow trench isolation structure 24, 24a extends through all layers (e.g., semiconductor handle wafer 22a, insulator layer 22b and top semiconductor layer 22c) of the semiconductor substrate 22, in SOI technology. The lined trench structure 20 will prevent the contact strap 18 from punching through, e.g., shorting to, an underlying semiconductor handle wafer 22a or a top semiconductor layer 22c.

More specifically, the structure 10 includes a semiconductor substrate 22. In embodiments, the semiconductor substrate 22 may be semiconductor-on-insulator technology. For example, the semiconductor substrate 22 may include a semiconductor handle wafer 22a, a buried insulator layer 22b and a top semiconductor layer 22c. The semiconductor handle wafer 22a provides mechanical support to the buried insulator layer 22b and the top semiconductor layer 22c.

The semiconductor handle wafer 22a and the top semiconductor layer 22c may comprise any suitable semiconductor material such as, for example, Si, Ge, SiGe, SiC, SiGeC, a III-V compound semiconductor, a II-VI compound semiconductor or any combinations thereof. The semiconductor handle wafer 22a and the top semiconductor layer 22c may comprise any suitable single crystallographic orientation (e.g., a (100), (110), (111), or (001) crystallographic orientation).

The buried insulator layer 22b may include a dielectric material such as silicon dioxide, silicon nitride, silicon oxynitride, boron nitride or a combination thereof. An exemplary insulator layer may be a buried oxide layer (BOX). In embodiments, the buried insulator layer may be formed by a deposition process, such as chemical vapor deposition (CVD), plasma enhanced chemical vapor deposition CVD (PECVD) or physical vapor deposition (PVD), or a thermal growth process, such as thermal oxidation as is known in the art. In yet another embodiment, the buried insulator layer 22b can also be formed by implanting oxygen atoms into a bulk semiconductor substrate and thereafter annealing the structure.

Shallow trench isolation structures 24, 24a may be formed in the semiconductor substrate 22 and, more particularly, may extend into the underlying semiconductor handle wafer 22a. The shallow trench isolation structures 24, 24a can be formed by conventional lithography, etching and deposition methods known to those of skill in the art. For example, a resist formed over the top semiconductor layer 22c is exposed to energy (light) and developed utilizing a conventional resist developer to form a pattern (opening). An etching process with a selective chemistry, e.g., reactive ion etching (RIE), will be used to transfer the pattern from the photoresist layer to form one or more trenches in the semiconductor substrate 22 through the openings of the resist. Following the resist removal by a conventional oxygen ashing process or other known stripants, insulator material (e.g., silicon dioxide) can be deposited by any conventional deposition processes, e.g., CVD process. Any residual material on the surface of the semiconductor substrate 22 can be removed by conventional chemical mechanical polishing (CMP) processes.

FIG. 1 further shows the adjacent gate structures 12, 14 with a common source/drain region 16 and respective drain/source region 26. In embodiments, the gate structures 12, 14 may be formed on opposing sides of the shallow trench isolation structure 24a and, more specifically, on opposing sides of the lined trench structure 20. Also, in embodiments, the source/drain region 16 are adjacent to facing sides of the gate structures 12, 14.

The shallow trench isolation structure 24a may extend through all layers (e.g., semiconductor handle wafer 22a, insulator layer 22b and top semiconductor layer 22c) of the semiconductor substrate 22 may contact the insulator layers 20a underneath the contact strap 18. Accordingly, it should be recognized by one of skill in the art that the active regions of the device may be completely isolated by the shallow trench isolation etch extending through the semiconductor handle wafer 22a, insulator layer 22b and top semiconductor layer 22c, prior to filling the shallow trench isolation structures 24, 24a with insulator material, e.g., oxide using a CVD deposition process and CMP process. In embodiments, the fill process of the shallow trench isolation regions 24, 24a may be performed prior to the formation of the gate structures 12, 14 and source/drain regions 26. Moreover, the height of the shallow trench isolation structures 24, 24a may be higher or lower than the top semiconductor layer 22c and source/drain regions 26, e.g., raised source/drain regions 26. In the case of being lower, it should be understood that this may result from an underfill of the trench used to form the shallow trench isolation structures 24, 24a.

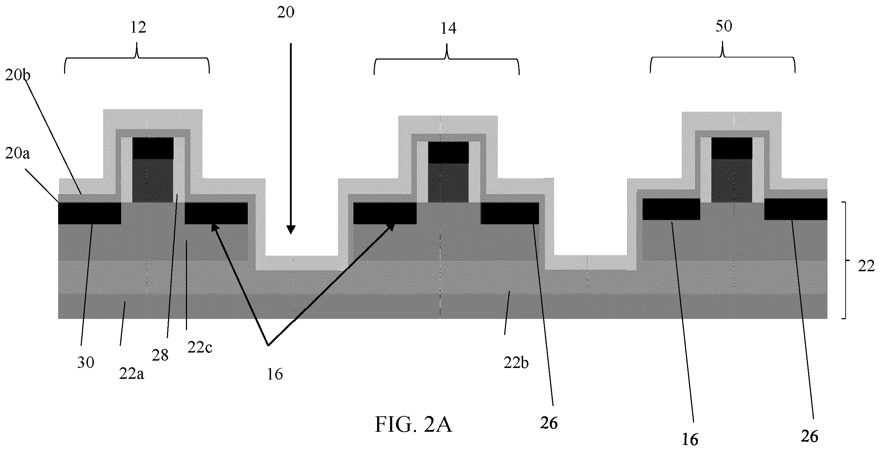

Although not critical to the understanding of the present disclosure, the adjacent gate structures 12, 14 can be fabricated using conventional CMOS processes as described with respect to FIG. 2A, with a gate dielectric and polysilicon material (designated at reference numerals 12a, 14a) and sidewall spacers 28. The common source/drain region 16 and respective drain/source region 26 may be raised diffusion regions formed by an in-situ doped epitaxial process as described with respect to FIG. 2A.

The lined trench structure 20 may be provided between the adjacent gate structures 12, 14. In embodiments, the lined trench structure 20 may include alternative insulator layers 20a, 20b. For example, the insulator layer 20a may be silicon dioxide and the insulator layer 20b may be a nitride material. In further embodiments, the insulator layer 20a should preferably have an etch selectivity to the insulator layer 20b. The insulator layers 20a, 20b may be used as stress liners to improve the efficiency of the gate structures 12, 14 as is known in the art. For example, a nitride liner may provide a tensile stress over an NFET. In further embodiments and as described with respect to FIGS. 2A-2F, an additional insulator layer 20c (e.g., silicon dioxide) may be provided over the insulator layer 20b, outside of the lined trench structure 20.

The contact strap 18 may electrically and physically connect (e.g., contact) to the common source/drain region 16, while also extending within and over the lined trench structure 20. In embodiments, the selective insulator layers 20a, 20b will prevent a punch-through to the semiconductor substrate 22 during the formation of the contact strap 18 (e.g., etching of interlevel dielectric material), thereby preventing shorting of the contact strap 18 to the underlying semiconductor handle wafer 22a or top semiconductor layer 22a. In other words, the selective insulator layers 20a, 20b will prevent the contact strap 20 from penetrating to the underlying semiconductor handle wafer 22a or top semiconductor layer 22c.

FIG. 1 further shows silicide contacts 30 to the gate structures 12, 14 as well as the source/drain regions 16, 26. As should be understood by those of skill in the art, the silicide process begins with deposition of a thin transition metal layer, e.g., nickel, cobalt or titanium, over fully formed and patterned semiconductor devices (e.g., doped or ion implanted source and drain regions 16, 26 and respective gate structures 12, 14). After deposition of the material, the structure is heated allowing the transition metal to react with exposed silicon (or other semiconductor material as described herein) in the active regions of the semiconductor device (e.g., source, drain, gate contact region) forming a low-resistance transition metal silicide. Following the reaction, any remaining transition metal is removed by chemical etching, leaving silicide contacts 30 in the active regions of the device. It should be understood by those of skill in the art that silicide contacts will not be required when a gate structure is composed of a metal material.

The contact strap 18 and contacts 32 connect to the silicide contacts 30. In embodiments, the contact strap 18 and contacts 32 may be formed from any conventional conductive material. For example, the conductive material may be tungsten or aluminum, lined with Tan or TiN. The contact strap 18 and contacts 32 may be formed through an interlevel dielectric material 20d, e.g., silicon dioxide, by any conventional lithography, etching and deposition process as described with respect to FIGS. 2A-2F.

In embodiments, the contact strap 18 being common to the source/drain region 16 will lower the resistance to the neighboring gate structures 12, 14, while also providing no capacitance or resistance penalty. In further embodiments, the contact strap 18 may even lower capacitance should it be pushed to the boundary of the shallow trench isolation structure 24a.

FIGS. 2A-2F show respective fabrication processes for manufacturing the structure of FIG. 1 in accordance with aspects of the present disclosure. For example, FIG. 2A shows the adjacent gate structures 12, 14 with a trench structure 20 between the adjacent gate structures 12, 14. In addition, the structure of FIG. 2A shows an additional gate structure 50 formed in the same or similar manner as described with respect to the gate structures 12, 14. The gate structures 12, 14, 50 may be NFET or PFET gate structures as is known in the art, each of which include source/drain regions 16, 26. In a preferred embodiment, the gate structures 12, 14 are NFETs and the gate structure 50 is a PFET.

In the standard CMOS processing, a gate dielectric and polysilicon material (designated at reference numerals 12a, 14a in FIG. 1) are formed, e.g., deposited, onto the top semiconductor layer 22c. The gate dielectric may be blanket deposited using, for example, an atomic layer deposition (ALD) process and the polysilicon may be blanket deposited using a conventional CVD process. In embodiments, the gate dielectric can be a high-k gate dielectric material such as a hafnium oxide material. The gate dielectric and polysilicon material may be subjected to a patterning process, e.g., any conventional lithography and etching (RIE) processes.

The sidewall spacers 28 may be formed by blanket deposition of an insulator material over the patterned gate dielectric and polysilicon material. The insulator material may be nitride or oxide or combinations thereof. Following the blanket deposition process, CVD, an anisotropic etching process may be performed to form the sidewall spacers 28.

The source/drain regions 16, 26 may be formed by an in-situ doped epitaxial process. For example, epitaxy regions (source/drain regions) are formed by selectively growing a semiconductor material, e.g., silicon germanium or silicon on sides of the adjacent gate structures 12, 14. It should be understood by those of skill in the art that other semiconductor materials and compounds known in the art are contemplated for use herein. A p-type or an n-type impurity may be used as a dopant during the epitaxial process, depending on whether the resulting FET is a p-type FET or an n-type FET. For example, the in-situ dopant may be boron for a p-type FET and phosphorus for an n-type FET.

Examples of various epitaxial growth process apparatuses that can be employed in the present application include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth may be performed at a temperature of from 300° C. to 800° C. The epitaxial growth can be performed utilizing any well-known precursor gas or gas mixture. Carrier gases like hydrogen, nitrogen, helium and argon can be used.

The trench structure 20 may be formed by conventional lithography and etching processes as described herein. In embodiments, the conventional lithography and etching processes will remove the top semiconductor layer 20c between the adjacent gate structures 12, 14, preferably extending to and exposing the underlying insulator layer 22b. In embodiments, the etching process can extend into the underlying insulator layer 22b.

The trench structure 20 may be lined with insulator layers 20a, 20b, which are also formed over the gate structures 12, 14, 50. In embodiments, the insulator layers 20a, 20b may be an oxide layer and a nitride layer, respectively. The insulator layers 20a, 20b may be formed by conventional deposition process, e.g., blanket CVD processes.

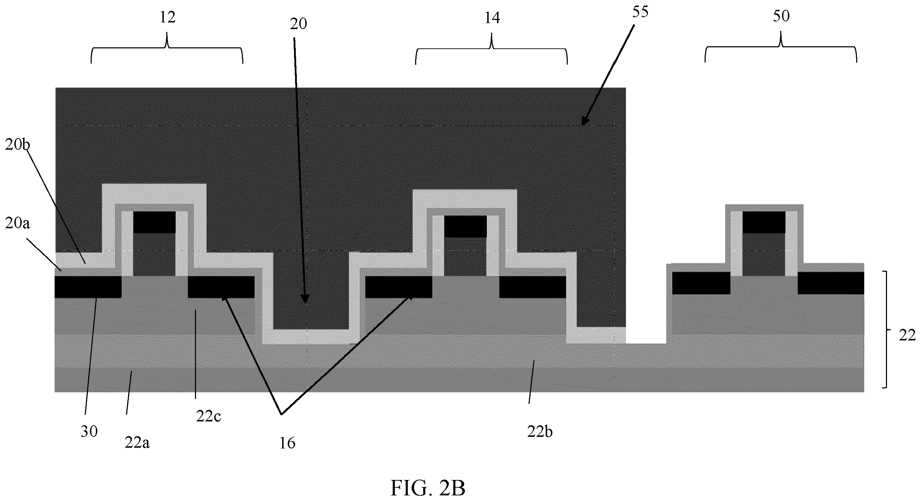

As further shown in FIG. 2B, a hardmask 55 may be formed over the gate structures 12, 14, followed by a patterning process to expose the underlying insulator layer 20b over the gate structure 50. For example, the hardmask 55 may be any known hardmask formed by conventional deposition processes, e.g., blanket CVD process. The exposed underlying insulator layer 20b over the gate structure 50 may be removed using a conventional etching process (e.g., RIE) known to those of skill in the art. In embodiments, the insulator layers 20a, 20b over the gate structures 12, 14 and within the trench 20 will be protected by the hardmask 55.

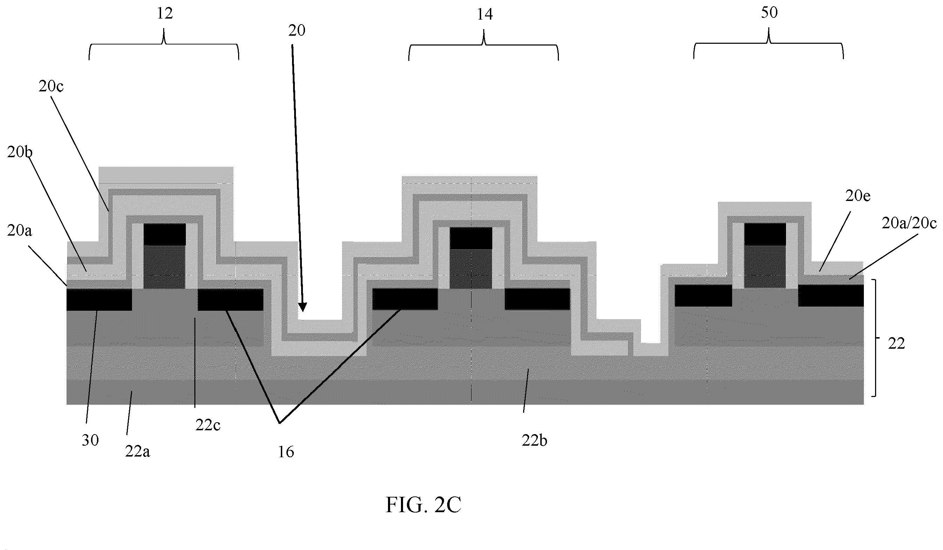

In FIG. 2C, the hardmask 55 may be removed by any conventional processes. etching, etc., and additional insulator layers 20c, 20e may be formed over the insulator layers 20a, 20b over the gate structures 12, 14 and the insulator layer 20a over the gate structures 50. The additional insulator layers 20c, 20e may also be formed within the trench 20 (over the insulator material 20b) between the adjacent gate structures 12, 14. In embodiments, the insulator layer 20c may be an oxide material and the insulator layer 20e may be a nitride material. The additional insulator layers 20c, 20e may be formed by conventional blanket deposition processes, e.g., CVD.

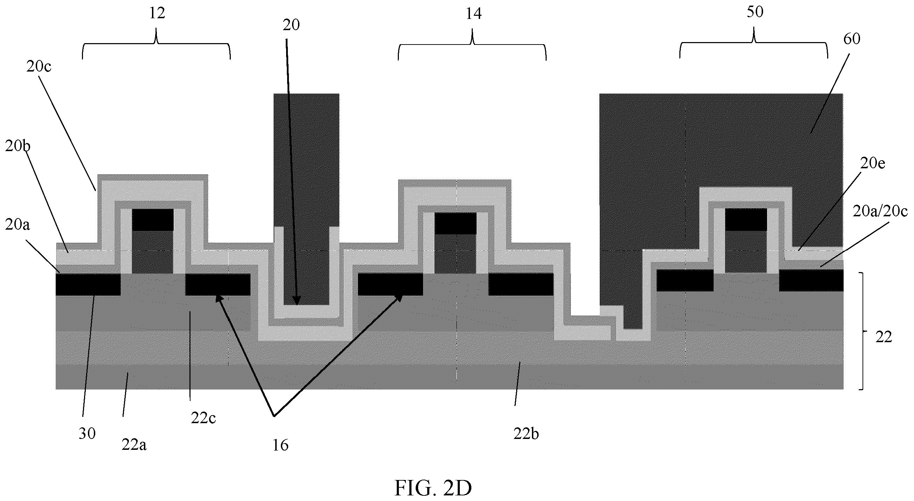

As further shown in FIG. 2D, a hardmask 60 may be formed over the gate structure 50 and within or over the trench 20, followed by a patterning process to expose the underlying insulator layer 20e over the gate structures 12, 14. The hardmask 60 may be any known hardmask formed by conventional deposition processes. The exposed underlying insulator layer 20e over the gate structures 12, 14 may be removed using a conventional etching process (e.g., RIE) known to those of skill in the art, while the insulator layer 20e remains protected within the trench 20 and over the gate structure 50 by the hardmask 60. The removal of the insulator layer 20e will expose the insulator layer 20c over the gate structures 12, 14.

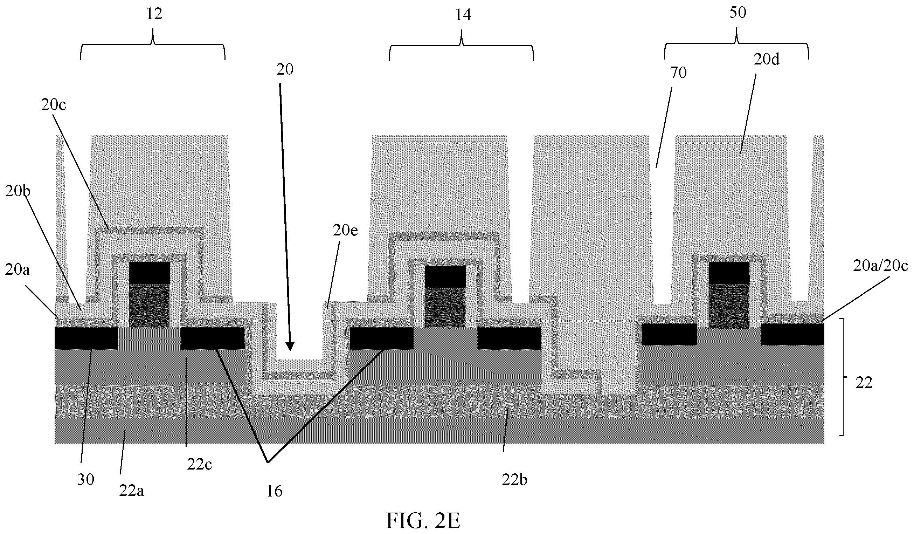

As further shown in FIG. 2E, an interlevel dielectric material 20d may be formed over the gate structures 12, 14, 50, followed by a patterning process to form trenches 70. The trenches 70 may expose the underlying insulator layer 20e in the trench 20 and over the source/drain regions 16, 26 of the gate structure 50, in addition to exposing the insulator layer 20c over the source/drain regions 16, 26 of the gate structures 12, 14. The interlevel dielectric material 20d may an oxide material, for example, deposited by a conventional CVD process. The exposed underlying insulator layer 20c over the gate structures 12, 14 may be removed using a selective etching process (e.g., RIE) known to those of skill in the art. By using a selective etching process, e.g., chemistry selective to the insulator layer 20c, the insulator layers 20e, 20b will not be removed.

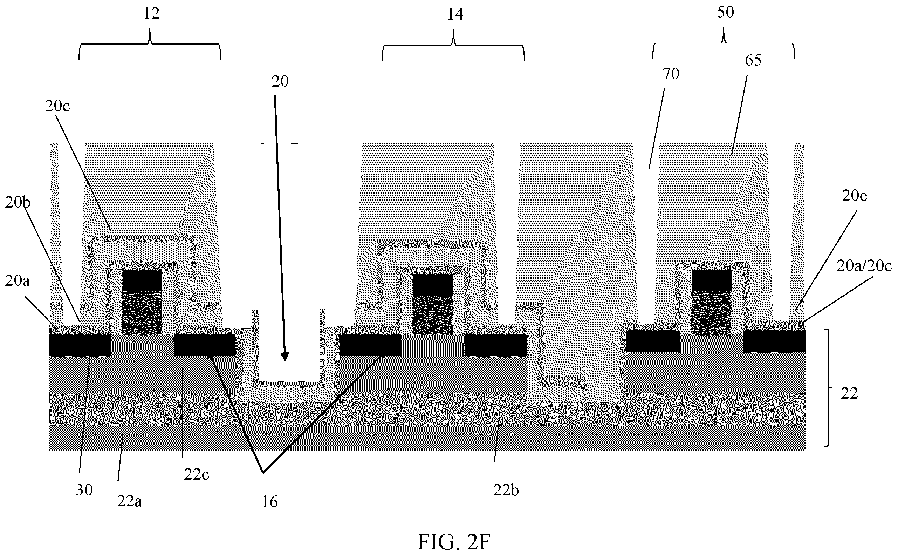

In FIG. 2F, a punch-through etch will remove the exposed insulator layers 20a, 20c, with the insulator layer 20b providing an etch stop within the trench 20. In this way, the punch-through etch will not punch through the insulator layer 20b and expose any underlying semiconductor material 22a, 22c. The punch-through etch will expose the underlying silicide contacts 30 in the source/drain regions 16, 26. Also, the insulator layer 20b will remain within the trench 20. Referring back to FIG. 1, the contact strap 18 and contacts 32 are formed by conventional deposition processes as already described herein.

The structure can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a first gate structure;
a second gate structure adjacent to the first gate structure;
a common diffusion region to the first gate structure and the second gate structure;
a trench lined with insulator material; and
a contact strap extending within the trench and connecting to the common diffusion region.

2. The structure of claim 1, wherein the contact strap extends over the insulator material of the trench.

3. The structure of claim 1 or claim 2, wherein the trench is between the first gate structure and the second gate structure.

4. The structure of one of claims 1 to 3, further comprising a shallow trench isolation structure under the trench.

5. The structure of one of claims 1 to 4, wherein the insulator material within the trench comprises a first insulator material and a second insulator material.

6. The structure of claim 5, wherein the first insulator material comprises oxide material and the second insulator material comprises nitride material, and/or wherein the first insulator material and the second insulator material are provided between the contact strap and an underlying semiconductor substrate.

7. The structure of one of claims 1 to 6, wherein the trench is formed in a top semiconductor layer of a semiconductor-on-insulator semiconductor substrate, and, optionally, wherein the trench extends to an underlying buried insulator material.

8. The structure of one of claims 1 to 7, wherein the insulator material comprise stress materials adjacent to the first gate structure and the second gate structure, and, optionally wherein the first gate structure and the second gate structure comprise NFETs and the stress materials comprise nitride material.

9. The structure of one of claims 1 to 8, wherein the common diffusion region comprises a raised epitaxial diffusion region facing sides of the first gate structure and the second gate structure.

10. A structure comprising:
a trench structure lined with insulator materials;
adjacent gate structures with a common diffusion region on opposing sides of the trench structure;
a shallow trench isolation structure underneath the trench structure; and
a contact extending over the trench structure and the shallow trench isolation structure and connecting to the common diffusion region.

11. The structure of claim 10, wherein the insulator materials within the trench structure comprise a nitride material over an oxide material, and, optionally, wherein the contact extends within the trench structure over the nitride material.

12. The structure of claim 10 or claim 11, wherein the trench structure extends to a buried insulator layer underneath a semiconductor on insulator substrate.

13. The structure of one of claims 10 to 12, wherein the first gate structure and the second gate structure are NFETs and the insulator materials comprise stress materials for the NFETs, and, optionally, wherein the adjacent gate structures are lined with the stress materials.

14. The structure of one of claims 10 to 13, wherein the common diffusion region comprises a raised diffusion region.

15. A method comprising:
forming a first gate structure;
forming a second gate structure adjacent to the first gate structure;
forming a common diffusion region to the first gate structure and the second gate structure;
forming a trench lined with insulator material; and
forming a contact strap extending within the trench and connecting to the common diffusion region.
